# EUROPÄISCHE PATENTSCHRIFT

(11) **EP 3 275 295 B1**
(45) Veröffentlichungstag und Bekanntmachung des Hinweises auf die Patenterteilung: **18.01.2023**
(21) Anmeldenummer: 16714303.1
(22) Anmeldetag: 21.03.2016
(51) Int. Cl.: H05K 3/28, H04R 25/00

(54) **VERFAHREN ZUR HERSTELLUNG EINER SCHALTUNG EINER HÖRHILFE**
METHOD FOR MANUFACTURING A CIRCUIT OF A HEARING AID
PROCÉDÉ DE FABRICATION D'UN CIRCUIT D'UN APPAREIL AUDITIF

(30) Priorität: 25.03.2015 DE 102015205431
(43) Veröffentlichungstag der Anmeldung: 31.01.2018
(73) Patentinhaber: Sivantos Pte. Ltd., Singapore 539775 (SG)
(72) Erfinder: BEYFUß, Stefanie, 91058 Erlangen (DE); KRAL, Holger, 90766 Fürth (DE); FREELS, Björn, 90429 Nürnberg (DE); KUHN, Johannes, 91058 Erlangen (DE)
(74) Vertreter: FDST Patentanwälte
(86) Internationale Anmeldenummer: PCT/EP2016/056146
(87) Internationale Veröffentlichungsnummer: WO 2016/150912

(56) Entgegenhaltungen:
- WO-A2-2013/172849
- KR-A- 20110 113 482
- US-A- 4 255 469
- US-A- 6 060 683

## Beschreibung

Die Erfindung betrifft ein Verfahren zur Herstellung einer Schaltung einer Hörhilfe. Die Schaltung weist eine Leiterplatte auf und ist insbesondere eine elektrische oder elektronische Schaltung.

Schaltungen weisen üblicherweise elektrische Bauteile und/oder elektronische Bauteile auf. Mittels dieser werden bestimmte Funktionen erfüllt, wofür es ist erforderlich, die einzelnen Bauteile miteinander elektrisch zu kontaktieren. Um eine vergleichsweise geringe Baugröße der Schaltung, eine vergleichsweise hohe Robustheit sowie eine vergleichsweise geringe Fertigungszeit zu erreichen, wird zur Herstellung von derartigen Schaltungen üblicherweise eine Leiterplatte verwendet.

Die Leiterplatte ist beispielsweise aus einem glasfaserverstärkten Epoxidharz gefertigt, an dem Leiterbahnen in einem fest vorgegebenen Layout positioniert sind. Hierbei befinden sich die Leiterbahnen, je nach Anforderungen an die Schaltung sowie deren Komplexität, an der Oberfläche oder aber sind in das Epoxidharz eingebettet, sodass eine mehrschichtige Leiterplatte bereitgestellt ist. Mit den einzelnen Leiterbahnen werden die elektrischen bzw. elektronischen Bauteile elektrisch kontaktiert, so dass die vorgegebene Funktionsweise der Schaltung realisiert wird. Die Befestigung erfolgt üblicherweise in einem Zug mit der elektrischen Kontaktierung, wofür die Bauteile an den Leiterbahnen angelötet werden.

Falls die Schaltung einer korrosiven Atmosphäre ausgesetzt ist, ist es erforderlich, nach der Anbringung der einzelnen Bauteile an der Leiterbahn diese sowie die Kontaktstellen und die Leiterbahnen selbst zu schützen. Falls die Schaltung Bestandteil einer Hörhilfe ist, muss die Schaltung daher sowohl gegen Schweiß eines Menschen als auch gegen Cerumen resistent sein, da diese entweder zu einer Beschädigung oder zu einem Kurzschluss der einzelnen Bauteile führen könnten. Es ist zudem erforderlich, dass die Schaltung vergleichsweise klein ausgeführt wird, so dass diese in den Gehörgang eines Menschen eingeführt werden kann oder dem Ohr Platz findet.

Zum Schutz der Leiterbahnen und der an der Leiterplatte angebrachten Bauteile wird üblicherweise eine Beschichtung verwendet. Hierbei werden bestimmte Bereiche, mittels eines Dispensprozesses mit einer flüssigen Beschichtung versehen. Bereiche, mit denen die Schaltung nach der Fertigung elektrisch kontaktiert wird, wie etwaige Batterieanschlüsse, werden vorher entweder mit einer Maske abgedeckt oder bleiben durch die Führung des Dispensprozesses und die auf den Prozess eingestellte Viskosität der flüssigen Beschichtung frei von dieser. Falls die Maske verwendet wird, wird die Schaltung mit Ausnahme der mittels der Maske abgedeckten Bereiche mittels der Beschichtung versehen. Nach Aushärten der Beschichtung wird die Maske von der Leiterplatte entfernt. Hierfür muss zunächst um die Maske herum die Beschichtung aufgetrennt werden, was üblicherweise mittels eines Lasers oder vergleichsweise scharfkantiger sowie präzise gefertigter Werkzeuge erfolgt. Insbesondere bei vergleichsweise filigranen Leiterplatten, wie dies bei Hörgeräten der Fall ist, ist eine Beschädigung der Leiterplatte aufgrund eines zu stark ausgeübten Druckes mittels des scharfkantigen Werkzeugs oder aber einem nicht korrekt eingestellten Laser nicht ausgeschlossen, so dass die Funktionsweise der Schaltung beeinträchtigt ist.

Falls die Maske ohne vorheriges Auftrennen der Beschichtung entfernt werden sollte, ist es möglich, dass die Beschichtung sich nicht nur im Bereich der Maske sondern auch in weiteren Bereichen der Schaltung löst, so dass die Isolierung auch an den Stellen entfernt wird, an der diese erwünscht ist. Folglich ist die Schaltung lediglich partiell beschichtet und somit auch einer Beschädigung aufgrund einer korrosiven Atmosphäre ausgesetzt. Infolgedessen ist bei der Produktion der Ausschuss erhöht. Zudem sind vergleichsweise kostenintensive Werkzeuge erforderlich.

Aus KR 2011 0113482 A ist ein Verfahren zur Herstellung einer Schaltung bekannt. Die Schaltung ist Bestandteil eines Röntgendetektorsensors.

Aus US 6,060,683 ist ein Verfahren zur Entfernung einer elektrischen Schicht von einer Leiterplatte bekannt.

US 4,255,469 offenbart ein Verfahren zur Beschichtung eines elektronischen Moduls mittels eines Bandes.

In WO 2013/172849 A2 ist ein Verfahren zur Herstellung einer Leiterplatte einer Hörhilfe offenbart, die einen elektromagnetischen Schild umfasst.

Aufgabe der Erfindung ist es, ein besonders geeignetes Verfahren zur Herstellung einer Schaltung anzugeben, bei dem die Kosten zur Herstellung der Schaltung insbesondere reduziert und vorzugsweise gleichzeitig die Fehleranfälligkeit reduziert ist.

Erfindungsgemäß wird diese Aufgabe durch die Merkmale des Anspruchs 1 gelöst. Vorteilhafte Weiterbildungen und Ausgestaltungen sind Gegenstand der Unteransprüche.

Das Verfahren dient der Herstellung einer Schaltung, insbesondere einer elektrischen oder elektronischen Schaltung. Unter Schaltung wird insbesondere ein Zusammenschluss von elektrischen und/oder elektronischen Bauteilen zu einer funktionierenden Anordnung verstanden. Die Schaltung ist Bestandteil einer Hörhilfe, wie eines Hörgeräts. Hörgeräte sind tragbare Hörvorrichtungen, die zur Versorgung von Schwerhörigen dienen. Hierbei gibt es beispielsweise Hinter-dem-Ohr-Hörgeräte, In-dem-Ohr-Hörgeräte oder auch Kanal-Hörgeräte (CONCHA-Hörgeräte). Mit anderen Worten dient das Verfahren der Herstellung einer Schaltung, die zur Herstellung eines derartigen Hörgeräts verwendet werden kann.

In einem ersten Arbeitsschritt wird eine Leiterplatte mit einem ersten und einem zweiten Bereich bereitgestellt. Der erste Bereich wird mittels einer Grenze von dem zweiten Bereich getrennt. Beispielsweise grenzen der erste und der zweite Bereich direkt aneinander an, und eben die Berührungsstellen der beiden Bereiche ist die Grenze. Vorzugsweise ist die Grenze geradlinig, zumindest abschnittsweise geradlinig ausgestaltet. Das Layout der Leiterplatte ist derart, dass im Montagezustand innerhalb des zweiten Bereichs diejenigen Bauteile und/oder Leiterbahnen der Schaltung positioniert sind, die mittels einer Beschichtung versehen sind, also diejenigen Bauteile bzw. Leiterbahnen, die bei bestimmungsgemäßen Einsatz der Schaltung insbesondere einer korrosiven Atmosphäre ausgesetzt sind. Dahingehend befinden sich im ersten Bereich diejenigen Abschnitte der Leiterbahnen, diejenigen Leiterbahnen und/oder diejenigen Bauteile der Schaltung, die nicht mittels einer Beschichtung versehen werden sollen, also beispielsweise Anschlüsse für Kabel oder weitere Bestandteile, beispielsweise weitere Bestandteile des Hörgeräts, sofern die Schaltung Bestandteil hiervon ist.

In einem weiteren Arbeitsschritt wird auf der Leiterplatte ein Bauteil angebracht. Das Bauteil wird auf der Grenze positioniert. Mit anderen Worten wird das Bauteil an der Leiterplatte auf der Grenze angebracht. Folglich wird die Grenze mittels des Bauteils abgedeckt. Insbesondere befindet sich ein Abschnitt des Bauteils jeweils im ersten und im zweiten Bereich. Das Bauteil wird an der Leiterplatte befestigt, so dass dieses ortsfest an der Leiterplatte gehalten wird. Mit nochmals anderen Worten überlappt das Bauteil die Grenze, so dass sowohl ein der Grenze zugewandter Abschnitt des ersten Bereichs als auch ein der Grenze zugewandter Abschnitt des zweiten Bereichs der Leiterplatte mittels des Bauteils abgedeckt ist. Hierbei ist das Bauteil vorzugsweise in direktem mechanischem Kontakt mit der Leiterplatte. Insbesondere ist die Leiterplatte im Bereich der Grenze mittels des Bauteils luft- und/oder flüssigkeitsdicht abgedeckt.

In einem weiteren Arbeitsschritt wird der erste Bereich mittels einer Maske abgedeckt. Mit anderen Worten wird die Maske luft- und/oder flüssigkeitsdicht auf den ersten Bereich gelegt, so dass aufgrund der Maske zwischen dem ersten Bereich und der Umgebung der Leiterplatte kein Gas- oder Flüssigkeitsaustausch stattfinden kann. Die Maske weist eine Kante auf, die auf dem Bauteil positioniert wird. Insbesondere entspricht die Form der Kante der Form der Grenze, und die Kante befindet sich auf der der Grenze gegenüberliegenden Seite des Bauteils. Zweckmäßigerweise liegt die Maske mittels der Kante formschlüssig an dem Bauteil an, also bündig. Insbesondere ist die Kante deckungsgleich mit der Grenze.

In einem weiteren Arbeitsschritt wird die Leiterplatte mit einer Beschichtung versehen. Hierbei wird die Beschichtung aus der Umgebung der Leiterplatte heraus auf diese aufgetragen, sodass der zweite Bereich der Leiterplatte mittels der Beschichtung versehen wird. Da der erste Bereich mittels der Maske abgedeckt wird, wird die Maske mit der Beschichtung versehen, wohingegen der erste Bereich frei von der Beschichtung verbleibt. Als Beschichtung wird zweckmäßigerweise eine elektrisch isolierende Beschichtung verwendet. Vorzugsweise wird in einem weiteren Arbeitsschritt die Beschichtung ausgehärtet, sofern diese beim Auftragen nicht bereits in einem festen Zustand ist. Auf diese Weise ist ein ungewolltes Ablösen der Beschichtung von dem zweiten Bereich der Leiterplatte im Wesentlichen ausgeschlossen.

In einem weiteren Arbeitsschritt wird die Beschichtung im Bereich des Bauteils aufgetrennt. Insbesondere verläuft die Linie der Auftrennung auf der der Leiterplatte gegenüberliegenden Seite des Bauteils. Beispielsweise ist die Linie der Auftrennung deckungsgleich mit der Grenze zwischen dem ersten und dem zweiten Bereich. Hierbei wird die Leiterplatte mittels des Bauteils vor etwaigen Beschädigungen geschützt. Bei einem tieferen Eindringen eines hierfür verwendeten Werkzeugs wird nämlich zunächst das Bauteil beschädigt. Auch bildet das Bauteil bei einer Druckausübung eine Stabilisierung der Leiterplatte, so dass diese nicht bricht.

In einem weiteren Arbeitsschritt wird die Maske entfernt. Da die Beschichtung im Bereich des Bauteils aufgetrennt wurde, werden bei Entfernen der Maske keine Kräfte auf die im zweiten Bereich der Leiterplatte aufgebrachte Beschichtung ausgeübt. Folglich verbleibt die Beschichtung im zweiten Bereich. Geeigneterweise wird das Bauteil auf der Leiterplatte belassen, und die Schaltung wird im gewünschten Anwendungsbereich verbaut, beispielsweise in dem Hörgerät. Aufgrund des Verfahrens ist sichergestellt, dass der zweite Bereich der Schaltung stets mittels der Beschichtung versehen ist, wobei aufgrund des Bauteils eine Beschädigung der Leiterplatte ausgeschlossen ist. Folglich können einerseits vergleichsweise kostengünstige Werkzeuge zur Auftrennung der Beschichtung verwendet werden, und andererseits ist eine Beeinträchtigung der Funktion der Leiterplatte ausgeschlossen.

Beispielsweise weist die Leiterplatte eine Vielzahl an Schaltungen auf, die beispielsweise gleichartig ausgestaltet sind. Nach Entfernen der Maske werden geeigneterweise die einzelnen Schaltungen aus der Leiterplatte herausgetrennt, beispielsweise gebrochen oder geschnitten. Mit anderen Worten wird die Leiterplatte aufgetrennt, und jede Schaltung umfasst einen Abschnitt der Leiterplatte, wobei die Schaltungen zueinander getrennt sind. Auf diese Weise kann mittels Ausführung des Verfahrens eine Vielzahl an Schaltungen hergestellt werden.

Geeigneterweise wird die Leiterplatte mittels der Beschichtung besprüht. Beispielsweise liegt die Beschichtung flüssig vor. Hierbei wird die Beschichtung vorzugsweise zunächst zerstäubt, also in eine Tröpfchenform verbracht und mittels dieser die Leiterplatte versehen. Besonders bevorzugt jedoch wird eine gasförmige Beschichtung gewählt. Mit anderen Worten wird das Material der Beschichtung vor Versehung der Leiterplatte in einen gasförmigen Zustand verbracht, und die Leiterplatte mittels des auf diese Weise erstellten Gases bedampft. Auf diese Weise ist die Funktion der Beschichtung verbessert und es ist ein Ausbilden von Blasen in der Beschichtung verhindert. Zudem werden auch vergleichsweise schwer zugängliche Bereiche der Leiterplatte, wie Hohlräume oder Ecken mittels der Beschichtung versehen. Insbesondere kondensiert die gasförmige Beschichtung an der Leiterplatte und bildet auf diese Weise einen Schutzfilm aus.

Beispielsweise wird als Beschichtung eine Polymerdispersion verwendet, beispielsweise Latex. Besonders bevorzugt wird ein Parylen als Beschichtung verwendet. Eine derartige Beschichtung hält vergleichsweise stabil auf unterschiedlichsten Materialien, wobei eine elektrische Isolierung sichergestellt ist.

Geeigneterweise wird die Beschichtung mittels eines Lasers aufgetrennt, was zu einer vergleichsweise präzisen Auftrennung führt. Besonders bevorzugt jedoch wird die Beschichtung mittels einer Klinge aufgetrennt. Mit anderen Worten wird die Beschichtung im Bereich des Bauteils geschnitten. Geeigneterweise wird hierfür ein Messer verwendet. Auf diese Weise ist einerseits ein vergleichsweise kostengünstiges und andererseits ein vergleichsweise schnelles Auftrennen der Beschichtung ermöglicht, wobei Schutzvorrichtungen für Personen vergleichsweise einfach und kostengünstig ausfallen können.

Zweckmäßigerweise wird die Beschichtung entlang der Kante der Maske aufgetrennt. Folglich ist die Schnittlinie mittels der Kante vorgegeben. Auf diese Weise ist es ermöglicht, mittels der Kante oder weiterer Bestandteile der Maske das zur Auftrennung verwendete Werkzeug zu führen. Insbesondere falls als Werkzeug ein Messer verwendet wird, wird auf diese Weise ein Abrutschen des Messers verhindert, das zu einer Beschädigung weiterer Bestandteile der Schaltung führen könnte. Alternativ oder in Kombination hierzu wird eine gezahnte Kante gewählt. Auf diese Weise ist ein Ablösen der Maske von dem Bauteil nach Auftrennen der Beschichtung erleichtet. Zudem ist, falls die Beschichtung entlang der Kante aufgetrennt wird, aufgrund der gezahnten Kante eine Kraftausübung auf das verwendete Werkzeug verringert, welches lediglich im Bereich der Zähne an der Maske anliegt. Mit anderen Worten wird die Beschichtung lediglich im Bereich der Zähne entlang der Kante aufgetrennt, wobei zweckmäßigerweise mittels dieser Bereiche eine Gerade definiert wird, entlang derer die Beschichtung aufgetrennt wird. Zudem wird aufgrund der gezahnten Kante eine etwaige Beschädigung der Maske verringert, so dass diese für eine vergleichsweise große Anzahl an Verfahren zur Herstellung der Schaltung wiederverwendet werden kann.

Beispielsweise wird eine Maske verwendet, die aus einem Gummi oder einem Silikon erstellt wurde. Auf diese Weise ist die Maske vergleichsweise flexibel und elastisch und/oder plastisch verformbar, so dass die Anbringung und das anschließende Entfernen erleichtert werden. Zudem ist somit auch ein Ausgleich von etwaigen Unebenheiten ermöglicht, weswegen der erste Bereich zuverlässig abgedeckt ist. Alternativ hierzu ist die Maske aus einem Metall gefertigt. Folglich ist die Maske vergleichsweise stabil. Besonders bevorzugt ist zumindest die Kante der Maske aus einem Metall gefertigt. Geeigneterweise wird nach erfolgter Beschichtung die Kante gegen das Bauteil gepresst, so dass die Beschichtung auf diese Weise im Bereich der Kante aufgetrennt wird. Mit anderen Worten dient die Kante als Klinge zum Auftrennen der Beschichtung. Falls die Kante gezahnt ist, wird die Beschichtung auf diese Weise perforiert. Beispielsweise wird das Bauteil im Bereich der Kante zumindest teilweise plastisch verformt. Insbesondere wird somit ein Abdruck der Kante innerhalb des Bauteils angefertigt, wobei die Eindringtiefe vorzugsweise geringer als 1 mm, 0,5 mm oder 0,1 mm ist. Auf diese Weise ist eine Beschädigung der Leiterplatte ausgeschlossen.

Beispielsweise ist der erste Bereich ein Randbereich der Leiterplatte. Mit anderen Worten wird der Randbereich der Leiterplatte nicht mittels der Beschichtung versehen. Auf diese Weise ist eine elektrische Kontaktierung der Schaltung nach der Fertigung erleichtert. Beispielsweise weist die Maske einen Spalt auf, innerhalb dessen die Leiterplatte eingelegt wird. Mit anderen Worten wird der erste Bereich mittels der Maske abgedeckt, indem die Leiterplatte in den Spalt eingefügt wird. Vorzugsweise ist der erste Bereich ein Randbereich der Leiterplatte und die Maske weist den Spalt auf. Folglich wird mittels der Maske der Randbereich abgedeckt, der in den Spalt eingelegt wird. Insbesondere ist die Tiefe des Spaltes gleich der Ausdehnung des ersten Bereiches. Besonders bevorzugt ist die Grenze eine gerade Linie, die geeigneterweise parallel zu einer Kante der Leiterplatte ist.

Das Bauteil wird mittels SMD-Technik an der Leiterplatte befestigt. Auf diese Weise ist die Herstellungszeit verkürzt. Beispielsweise ist das Bauteil ein SMD-Bauteil oder weist eine Vielzahl derartiger SMD-Bauteile auf, die geeigneterweise in direktem Kontakt zueinander stehen, sodass die vollständige Grenze mittels der SMD-Bauteile des Bauteils überdeckt sind.

Ein weiteres elektronisches oder elektrisches Bauteil wird mittels SMD-Technik an der Leiterplatte befestigt. Geeigneterweise werden mehrere elektronische und/oder elektrische Bauteile mittels SMD-Technik an der Leiterplatte befestigt. Die Befestigung dieser Bauteile erfolgt im gleichen Arbeitsschritt, wie im Arbeitsschritt, in dem das Bauteil an der Leiterplatte angebracht wird. Das elektronische bzw. elektrische Bauteil ist geeigneterweise mittels einer Leiterbahn der Leiterplatte elektrisch kontaktiert. Bei Betrieb der Schaltung wird mittels des elektrischen bzw. elektronischen Bauteils eine Funktion wahrgenommen.

Beispielsweise ist das Bauteil, das auf der Grenze positioniert wird, aus einem Metall oder einer Keramik gefertigt. Auf diese Weise ist das Bauteil vergleichsweise resistent gegen eine Beschädigung, wenn die Beschichtung aufgetrennt wird. Beispielsweise ist das Bauteil streifenförmig ausgestaltet, insbesondere ein Metallstreifen. In einer Alternative ist das Bauteil mittels einer weiteren Leiterplatte realisiert, die insbesondere streifenförmig ausgestaltet ist.

Geeigneterweise wird das Bauteil lediglich mit der Leiterplatte elektrisch kontaktiert. Insbesondere nimmt das Bauteil bei Betrieb der Schaltung keine Funktion wahr. Mit anderen Worten ist das Bauteil nicht für die Funktion der Schaltung ausschlaggebend. Beispielsweise ist das Bauteil ein sogenanntes Dummy, insbesondere ein Dummy SMD-Bauteil.

Geeigneterweise ist das Bauteil mit keiner Leiterbahn elektrisch kontaktiert. Sofern das Bauteil mittels SMD-Technik an der Leiterplatte befestigt wird, ist dieses vorzugsweise lediglich mit elektrisch isolierten Kontakt- bzw. Lötflächen ("Pad") elektrisch kontaktiert, die mit keiner weiteren Leiterbahn elektrisch kontaktiert sind. Auf diese Weise ist eine Beeinflussung der Schaltung aufgrund des Bauteils ausgeschlossen. Sofern folglich bei der Auftrennung der Beschichtung das Bauteil beschädigt werden sollte, ist die Funktion der Schaltung nicht beeinträchtigt.

Nachfolgend wird ein Ausführungsbeispiel der Erfindung anhand einer Zeichnung näher erläutert. Darin zeigen:
- FIG 1: Schematisch ein Verfahren zur Herstellung einer Schaltung,
- FIG 2: perspektivisch verschiedene Arbeitsschritte zur Behandlung einer Leiterplatte,
- FIG 3: ausschnittsweise eine gezahnte Kante einer Maske,
- FIG 4: perspektivisch ein Bauteil,
- FIG 5: in einer Draufsicht die Schaltung, und
- FIG 6: schematisch vereinfacht eine Hörhilfe.

Einander entsprechende Teile sind in allen Figuren mit den gleichen Bezugszeichen versehen.

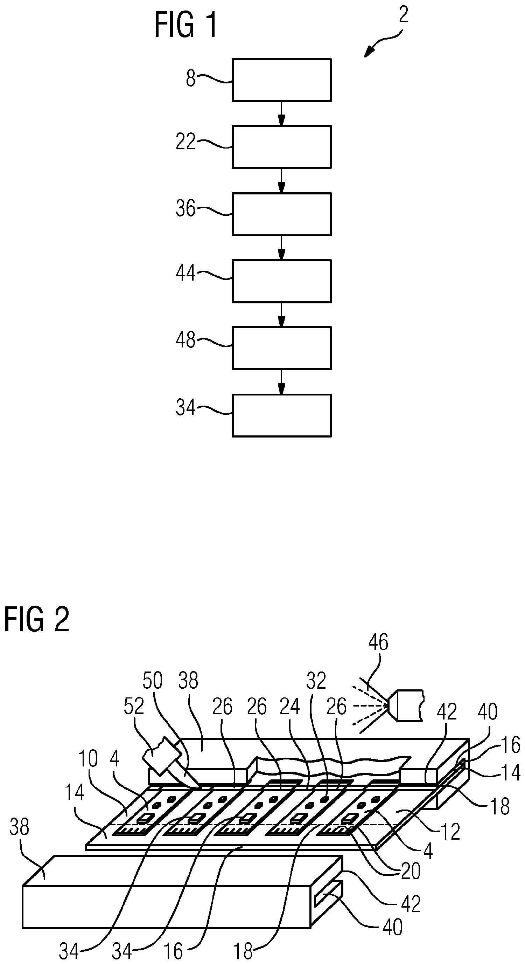

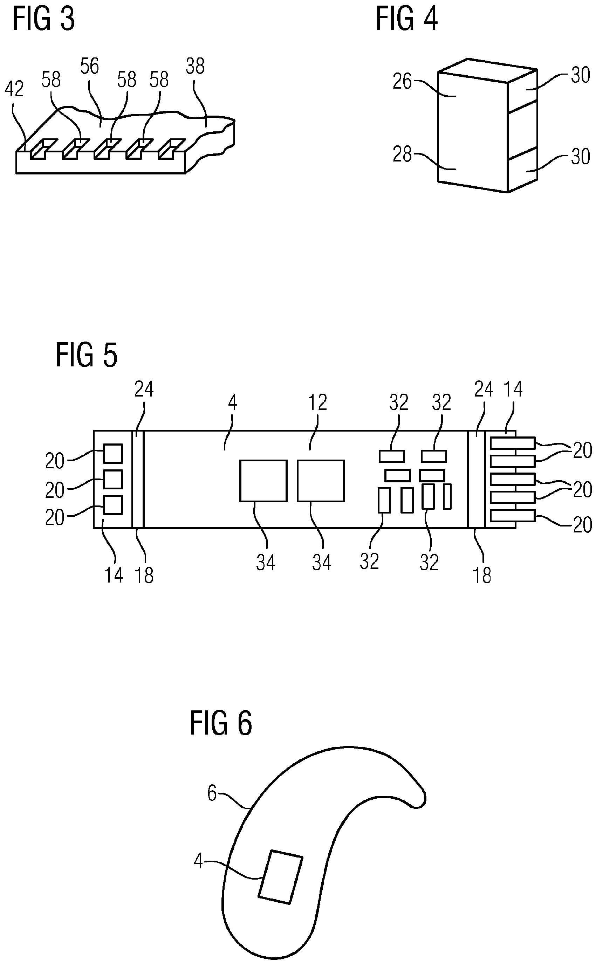

In FIG 1 ist ein Verfahren 2 zur Herstellung einer in FIG 5 dargestellten elektronischen Schaltung 4 gezeigt, die Bestandteil einer in FIG 6 dargestellten Hörhilfe 6 ist. In einem ersten Arbeitsschritt 8 wird eine in FIG 2 dargestellte Leiterplatte 10 bereitgestellt. Mittels der Leiterplatte 10 soll beispielsweise fünf Mal die gleiche Schaltung 4 erstellt werden. Die Leiterplatte 10 weist einen zweiten Bereich 12 auf, der bei Montage der Hörhilfe 6 in einem menschlichen Ohr menschlichem Schweiß ausgesetzt ist. Die Leiterplatte 10 weist ferner zwei erste Bereiche 14 auf, die zwei gegenüberliegende Randbereiche 16 der Leiterplatte 10 bilden. Hierbei ist der zweite Bereich 12 zwischen den beiden rechteckförmigen ersten Bereichen 14 positioniert und jeweils mittels einer Grenze 18 von diesen getrennt. Die Grenzen 18 sind jeweils geradlinig und zueinander parallel. Ferner berühren sich der zweite Bereich 12 und jeweils einer der ersten Bereiche 14 entlang der jeweiligen Grenze 18. Innerhalb der ersten Bereiche 14 befinden sich Kontaktstellen 20, mittels derer bei Montage der Hörhilfe 6 weitere Bestandteile der Hörhilfe 6 mit der Schaltung elektrisch kontaktiert werden.

In einem zweiten Arbeitsschritt 22 wird jeweils ein Bauteil 24 auf den Grenzen 18 positioniert und mittels SMD-Technik mit der Leiterplatte 10 verlötet. Das Bauteil 24 ist beispielsweise ein Metallstreifen, dessen Länge zumindest gleich der Länge der jeweiligen Grenze 18 ist. In einer Alternative hierzu weist das Bauteil 24 eine Anzahl von Dummy SMD-Bauteilen 26 auf, von denen eines in FIG 4 dargestellt ist. Das quaderförmige Dummy SMD-Bauteil 26 weist einen quaderförmigen Körper 28 auf, an dessen einer Seite zwei Pads 30 aus einem Metall befestigt sind. Folglich stellt keines der Dummy SMD-Bauteile 26 eine Funktion bereit. Die Dummy SMD-Bauteile 26 werden mit entsprechenden Pads der Leiterplatte 10 im zweiten Arbeitsschritt 22 verbunden. Die Dummy SMD-Bauteile 26 sind direkt zueinander benachbart angeordnet, so dass zwischen benachbarten Dummy SMD-Bauteilen 26 kein Platz verbleibt und eventuell vorhandene Schlitze mittels des verwendeten Lots verschlossen werden. Die Bauteile 24 sowie deren Bestandteile, die Dummy SMD-Bauteile 26, werden lediglich mit der Leiterplatte 10 elektrisch kontaktiert, also nicht mit den Anschlüssen 20 oder etwaigen Leiterbahnen. Mit anderen Worten sind die Bauteile 24 lediglich an Pads der Leiterplatte 10 angebunden, wobei die Pads zu weiteren Leiterbahnen der Leiterplatte 10 elektrisch isoliert sind.

Ebenfalls im zweiten Arbeitsschritt 22 werden elektrisch Bauteile 32 sowie elektronische Bauteile 34 mittels SMD-Technik mit der Leiterplatte 10 sowie deren Leiterbahnen elektrisch kontaktiert. Auf diese Weise ist eine Verbindung zwischen den einzelnen Kontaktstellen 20 sowie den elektrischen und elektronischen Bauteilen 32, 34 erstellt, und die Schaltung 4 ist funktionsfähig. Auch sind die elektrischen und elektronischen Bauteile 34 nicht mit den Bauteilen 24 elektrisch kontaktiert, sondern von diesem elektrisch isoliert.

In einem dritten Arbeitsschritt 36 wird jeder der ersten Bereiche 14 mittels einer zugeordneten Maske 38 abgedeckt, von denen eine in FIG 2 aufgebrochen dargestellt ist. Jede quaderförmige Masken 38 ist aus einem Gummi, einem Silikon oder einem Metall gefertigt und weist einen Spalt 40 auf, in den die Leiterplatte 10 eingelegt wird. Die Tiefe des Spaltes 40 ist gleich der Ausdehnung des ersten Bereichs 14, so dass die Leiterplatte 10 im ersten Bereich 14 formschlüssig von der Maske 38 umgeben wird. Mittels des Spalts 40 ist eine Kante 42 gebildet, die deckungsgleich zur Grenze 18 positioniert ist. Mit anderen Worten entspricht der Verlauf der Kante 42 dem Verlauf der jeweiligen Grenze 18, wobei jedoch das der jeweiligen Grenze 18 zugeordnete Bauteil 24 zwischen der Maske 38 und der Grenze 18 angeordnet ist. Infolgedessen ist die Kante 42 auf dem Bauteil 24 positioniert und überlappt dieses folglich.

In einem vierten Arbeitsschritt 44 wird die Leiterplatte 10 mittels einer gasförmigen Beschichtung 46 versehen. Als Beschichtung 46 wird ein Parylen verwendet. Aufgrund der Masken 38 wird lediglich der zweite Bereich 12 sowie Teile der Bauteile 24 und die Masken 38 mittels der Beschichtung 46 bedampft, wobei aufgrund der gasförmigen Phase einerseits eine Blasenbildung bei Anlagerung an der Leiterplatte 10 sowie der elektrischen und elektronischen Bauteile 32, 34 vermieden ist. Ferner werden auch sämtliche Ecken, Kanten sowie etwaige gebildete Hohlräume mittels der Beschichtung 46 versehen.

In einem fünften Arbeitsschritt 48 wird die auf der Leiterplatte 20 sowie den Bauteilen 24 als auch den Masken 38 ausgehärtete Beschichtung 46 mittels einer Klinge 50 aufgetrennt. Hierfür wird ein die Klinge 50 aufweisendes Messer 52 entlang der Kante 42 über das Bauteil 24 bewegt und somit die Beschichtung 46 entlang der jeweiligen Kante 42 der Maske 38 aufgetrennt. Hierbei schneidet die Klinge 50 partiell in das jeweilige Bauteil 24 ein, was jedoch die Funktion der Schaltung 4 nicht beeinträchtigt. In einer nicht gezeigten Alternative wird die Beschichtung 46 entlang der Kante 42 mittels eines Lasers aufgetrennt.

In einem sechsten Arbeitsschritt 54 werden die Masken 38 entfernt und die ersten Bereiche 14 freigegeben. Ferner werden die fünf in FIG 2 dargestellten Schaltungen 4 aus der Leiterplatte 10 herausgeschnitten oder gebrochen, so dass die in FIG 5 gezeigte Schaltung 4 erstellt ist.

In FIG 3 ist eine alternative Ausgestaltung der Maske 38 ausschnittsweise dargestellt. Die Maske 38 ist plattenförmig ausgestaltet, wobei die Größe der Maske 38 größer als der jeweilige erste Bereich 14 ist. Die der Leiterplatte 10 zuzuwendende Oberfläche 56 weist an einem ihrer Randbereiche Ausnehmungen 58 auf, so dass die auf den Bauteil 24 zu positionierende Kante 42 gezahnt ausgebildet ist. Nach Ausführung des vierten Arbeitsschritts 44 wird bei Verwendung dieser Maske 38 im fünften Arbeitsschritt 48 die Kante 42 gegen das jeweilige Bauteil 24 gepresst und folglich die Beschichtung 46 auf diese Weise perforiert, also aufgetrennt. Bei Entfernen der Maske 38 von der Leiterplatte 10 reißt folglich die Beschichtung 46 entlang der Perforierung auf, so dass die Beschichtung 46, die sich im zweiten Bereich 12 befindet, nicht beschädigt wird.

Die Erfindung ist nicht auf die vorstehend beschriebenen Ausführungsbeispiele beschränkt. Vielmehr können auch andere Varianten der Erfindung von dem Fachmann hieraus abgeleitet werden, ohne den Gegenstand der Ansprüche zu verlassen.

## Patentansprüche

1. Verfahren (2) zur Herstellung einer Schaltung (4) einer Hörhilfe (6), bei dem
- eine Leiterplatte (10) mit einem ersten Bereich (14) und mit einem zweiten Bereich (12), die mittels einer Grenze (18) getrennt sind, bereitgestellt wird,
- an der Leiterplatte (10) ein Bauteil (24) angebracht wird, wobei das Bauteil (24) auf der Grenze (18) positioniert wird,
- der erste Bereich (14) mittels einer eine Kante (42) aufweisenden Maske (38) abgedeckt wird, wobei die Kante (42) auf dem Bauteil (24) positioniert wird,
- die Leiterplatte (10) mit einer Beschichtung (46) versehen wird,
- die Beschichtung (46) im Bereich des Bauteils (24) aufgetrennt wird, und
- die Maske (38) entfernt wird, wobei
- im gleichen Arbeitsschritt das Bauteil (24) und ein weiteres elektronisches oder elektrisches Bauteil (32, 34) mittels SMD-Technik an der Leiterplatte (10) befestigt werden.

2. Verfahren (2) nach Anspruch -1, die dem eine gasförmige Beschichtung (46) und/oder ein Parylen als Beschichtung (46) gewählt wird.

3. Verfahren (2) nach Anspruch 1 oder 2, bei dem die Beschichtung (46) mittels einer Klinge (50) aufgetrennt wird.

4. Verfahren (2) nach einem der Ansprüche 1 bis 3, bei dem die Beschichtung (46) entlang der Kante (42) der Maske (38) aufgetrennt und/oder eine gezahnte Kante (42) gewählt wird.

5. Verfahren (2) nach einem der Ansprüche 1 bis 4, bei dem eine Maske (38) aus einem Gummi, einem Silikon oder einem Metall gewählt wird.

6. Verfahren (2) nach einem der Ansprüche 1 bis 5, bei dem als der erste Bereich (14) ein Randbereich (16) der Leiterplatte (10) und/oder eine Maske (38) mit einem Spalt (40) gewählt wird, innerhalb dessen die Leiterplatte (10) eingelegt wird.

7. Verfahren (2) nach einem der Ansprüche 1 bis 6, bei dem als Bauteil (24) ein aus einem Metall oder einer Keramik gefertigtes Bauteil gewählt wird.

8. Verfahren (2) nach einem der Ansprüche 1 bis 7, bei dem das Bauteil (24) lediglich mit der Leiterplatte (10) elektrisch kontaktiert wird.

## Claims

1. Method (2) for manufacturing a circuit (4) of a hearing aid (6), in which
- a printed circuit board (10) having a first region (14) and having a second region (12), which are separated by means of a border (18), is provided,
- a component (24) is attached to the printed circuit board (10), wherein the component (24) is positioned on the border (18),
- the first region (14) is covered by means of a mask (38) having an edge (42), wherein the edge (42) is positioned on the component (24),
- the printed circuit board (10) is provided with a coating (46),
- the coating (46) is split apart in the region of the component (24), and
- the mask (38) is removed, wherein
- in the same work step the component (24) and a further electronic or electrical component (32, 34) are mounted on the printed circuit board (10) by means of SMD technology.

2. Method (2) according to Claim 1, in which a gaseous coating (46) and/or a parylene is chosen as the coating (46) .

3. Method (2) according to Claim 1 or 2, in which the coating (46) is split apart by means of a blade (50).

4. Method (2) according to one of Claims 1 to 3, in which the coating (46) is split apart along the edge (42) of the mask (38) and/or a serrated edge (42) is chosen.

5. Method (2) according to one of Claims 1 to 4, in which a mask (38) made of a rubber, of a silicone or of a metal is chosen.

6. Method (2) according to one of Claims 1 to 5, in which an edge region (16) of the printed circuit board (10) and/or a mask (38) having a slot (40), inside which the printed circuit board (10) is inserted, is chosen as the first region (14).

7. Method (2) according to one of Claims 1 to 6, in which a component manufactured from a metal or from a ceramic is chosen as the component (24).

8. Method (2) according to one of Claims 1 to 7, in which the component (24) is electrically contact-connected only with the printed circuit board (10).

## Revendications

1. Procédé (2) permettant de fabriquer un circuit (4) d'un appareil auditif (6), dans lequel
- une carte de circuits intégrés (10) est fournie qui comprend une première zone (14) et une deuxième zone (12) qui sont séparées au moyen d'une limite (18),
- un composant (24) est installé sur la carte de circuits intégrés (10), le composant (24) étant positionné sur la limite (18),
- la première zone (14) est recouverte au moyen d'un masque (38) présentant un bord (42), le bord (42) étant positionné sur le composant (24),
- la carte de circuits intégrés (10) est munie d'un revêtement (46),
- le revêtement (46) est séparé dans la zone du composant (24), et
- le masque (38) est retiré, dans lequel
- dans la même étape de travail, le composant (24) et un autre composant électronique ou électrique (32, 34) sont fixés sur la carte de circuits intégrés (10) au moyen d'une technique SMD.

2. Procédé (2) selon la revendication 1, dans lequel un revêtement gazeux (46) et/ou du parylène est/sont choisi(s) comme revêtement (46).

3. Procédé (2) selon la revendication 1 ou 2, dans lequel le revêtement (46) est séparé au moyen d'une lame (50).

4. Procédé (2) selon l'une quelconque des revendications 1 à 3, dans lequel le revêtement (46) est séparé de long du bord (42) du masque (38) et/ou un bord dentelé (42) est choisi.

5. Procédé (2) selon l'une quelconque des revendications 1 à 4, dans lequel un masque (38) en caoutchouc, en silicone ou en métal est choisi.

6. Procédé (2) selon l'une quelconque des revendications 1 à 5, dans lequel on choisit comme la première zone (14) une zone marginale (16) de la carte de circuits imprimés (10) et/ou un masque (38) pourvu d'une fente (40) à l'intérieur de laquelle la carte de circuits intégrés (10) est insérée.

7. Procédé (2) selon l'une quelconque des revendications 1 à 6, dans lequel un composant fabriqué en métal ou en céramique est choisi comme composant (24) .

8. Procédé (2) selon l'une quelconque des revendications 1 à 7, dans lequel le composant (24) n'est mis en contact électrique qu'avec la carte de circuits intégrés (10).
